# EUROPEAN PATENT SPECIFICATION

(11) **EP 0 474 605 B1**
(45) Date of publication and mention of the grant of the patent: **12.10.1994**
(21) Application number: 91830293.6
(22) Date of filing: 02.07.1991
(51) Int. Cl.: H05K 3/30, H05K 3/46

(54) **Assembly and method of assembly for the application of electronic components to flexible printed circuits**
Anordnung und Verfahren zur Anordnung für den Einbau von elektronischen Bauelementen auf flexiblen gedruckten Schaltungen
Assemblage et méthode d'assemblage pour la fixation de composants électroniques sur des plaquettes flexibles à circuits imprimés

(30) Priority: 03.09.1990 IT 63090
(43) Date of publication of application: 11.03.1992
(73) Proprietor: R.I.C.O. - S.R.L., I-60022 Castelfidardo (AN) (IT)
(72) Inventor: Saraceni, Maurizio, I-60027 Osimo (IT)
(74) Representative: Baldi, Claudio

(56) References cited:
- EP-A- 0 117 809
- EP-A- 0 415 527
- DE-A- 3 414 552
- US-A- 4 916 807

## Description

This application for a patent has as its object a method of assembly and relative assembled finished product, for applying a normal electronic component such as for example resistances, condensors, leds, diodes, chips etc., to a Flexible Printed Circuit.

For Flexible Printed Circuit, normaly denominated by the abbreviation "Flex.P.C.", we understand as being a series of serigraphed conductors using conductor paste on a thin sheet of flexible backing usually made of a film of plastic material, such as for example Polystyrene, Polyamids or ethylene resin.

The assembly of the electronic components on these Flexible Printed Circuits presents numerous difficulties; the welding methods traditionally used on printed circuits cannot be used with "Flex.P.C." in that the conductor paste, because of its very nature and composition cannot be welded to the connections of the components.

At present conductor bonding agents are used which once they reach their polymerization temperature are able to guarantee a reliable and strong connection.

This assembly technique however requires time and its costs are high.

It should also be remembered that the adherance of the conductor to the supporting flexible film is however rather weak and precarious so it is easy for an accidental break to occur between the parts above all if the film is bent near the connection point of the component.

In order to avoid this risk and to increase the reliability of this blocking system the electronic component and its connection could be encapsulated by covering them with a high bond rigid resin, but this would mean a further cycle in the oven with consequent increase in time and production costs. US-A-4 916 807 discloses a method for assembling circuits having surface mounted components. Surface mounted circuit components having surface mount leads are mounted upon circuit boards having corresponding patterns of surface mount pads by a procedure wherein molds having recesses are mounted upon a universal back board along with alignment pins and production circuit components are inserted therein. Production circuit boards then are positioned over the molds and inserted circuit components along with an adhesive for use in subsequent flow soldering connections, or a Re-Flow solder for that form of lead connection. A retainer is positioned over the assembled circuit board and the assemblage is inverted to expose the assembled circuit boards for soldering processing.

The object of this invention is to resolve the inconveniences outlined above by creating a new assembly method capable of guaranteeing maximum reliability as regards the stability of the connections and reducing time and costs as regards the assembly operation.

The invention is defined in method claim 1 and product claim 2.

The assembly method according to claim 1 forsees the use of a plate and a counterplate, stamped out of a rigid plastic material between which the various electronic components will be housed and blocked, each component being inserted into fitted housings and suitable for the purpose shaped in the internal wall of the plate against which is placed the surface of the flexible film, "Flex.P.C.", e.g. on which the conductors have been placed and which in this way may be positioned exactly in line with the contacts of the electronic components.

Between the flexible supporting film for the conductors and the counterplate cover a "mattress" made of an elastomer such as silicon or neoprenic rubber will be inserted which, correctly pressed will guarantee an efficient and reliable contact between the "Flex.P.C." conductor and the electronic component even under adverse conditions as in the presence of vibration or knocks which as is well known are the most dangerous types of stress.

The elastic deformation of this soft elastomer "mattress" also guarantees automatic compensation for any defects in flatness of the internal surfaces of the plate and counterplate between which the "Flex.P.C." is blocked and perhaps even sealed should such protection be required.

In order to be more explicit the description of the invention continues in reference to the enclosed drawings which are simply illustrative and not limiting, in which:
- Fig.1 shows, through a schematic plan, a "Flex.P.C." on which the electronic components have been mounted using the assembly method of the invention
- Fig.2 shows, through a cross section diagram, a "Flex.P.C." on which the electronic components have been mounted using the assembly method of the invention.

With reference to the aforesaid figures the assembly method according to the invention forsees the following operative phases:
a) placing of electronic components (1) into fitted housings shaped in the internal wall of a supporting plate stamped out of a rigid plastic material;
b) positioning of "Flex.P.C." (3) against the plate (2) so that the conductors (3a) placed on the "Flex.P.C." are facing the plate (2);
c) laying of an elastomer "mattress" (4) on the "Flex.P.C."(3);
d) Pressing of "mattress" (4) against the plate (2) using the counterplate cover (5), also stamped out of a rigid plastic material, which is fixed, using suitable normal blocking systems, to the component holder plate (2).

The component holder plate (2) is furnished with reference pins (2a) in order to line up the conductors (3a) of the "Flex.P.C." with the contacts (1a) of the components (1).

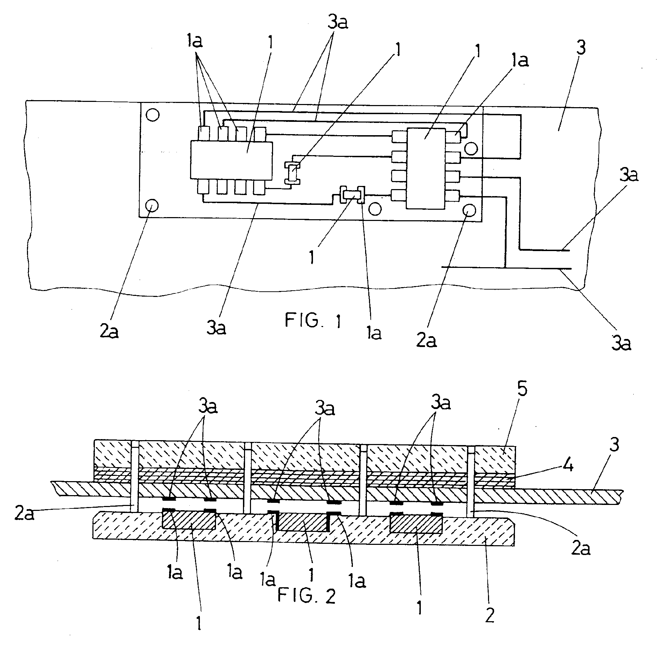

The same pins (2a) are used as centering elements for the "materass" (4) and the counterplate (5), which can be blocked either by using normal screws or by riveting the pins (2a) as shown in Fig.1 where the riveted point of the pins (2a) is illustrated.

## Claims

1. Method of assembly for the application of electronic components to Flexible Printed Circuits ("Flex.P.C."), involving the following operative phases:
a) placing of electronic components (1) into fitted housings shaped in the internal wall of a supporting plate stamped out of a rigid plastic material;
b) positioning of "Flex.P.C."(3) against the plate (2) so that the conductors (3a) placed on the "Flex.P.C." are facing the internal wall of the plate (2);
c) laying of an elastomer "mattress" (4) on the opposite side of "Flex.P.C." (3);
d) pressing the "mattress" (4) against the plate (2) using a counterplate cover (5), also stamped out of a rigid plastic material, which is fixed, using suitable normal blocking systems, to the component holder plate (2).

2. Assembled product obtainable using the assembly method as described in the first claim, including a "Flex.P.C." (3) blocked between a plate (2) and a counterplate (5), the plate (2) and the counterplate (5) being stamped out of rigid plastic, an elastomer "mattress" (4) being inserted between the "Flex.P.C." and the counterplate, wherein the counterplate presses the conductors (3a) of the "Flex.P.C." (3) against contacts (1a) of electronic components (1) correctly placed in fitted housings shaped in the internal wall of the plate (2).

## Patentansprüche

1. Montageverfahren zum Einbau von elektronischen Bauteilen auf flexiblen Leiterplatten ("Flex. P.C."), das folgende Arbeitsgänge beinhaltet:
a) Anbringung der elektronischen Bauteile (1) an gleichförmigen Befestigungsstellen, die an der Innenseite einer Stützplatte (2) herausgearbeitet sind, welche aus steifem Plastik gepreßt ist;
b) Anbringung der "Flex. P.C." (3) auf der Platte (2) derart, daß die Leiter (3a), die auf der "Flex. P.C." angebracht sind, in Richtung der Innenseite der Platte (2) weisen;
c) Auftragen einer Elastomer-"Matte" (4) auf der entgegengesetzten Seite der "Flex.P.C." (3);
d) Andrücken der "Matte" (4) gegen die Platte (2) mittels einer Deck-Gegenplatte (5), ebenfalls aus steifem Plastikmaterial gepreßt, welche durch geignete und herkömmliche Fixiermittel auf der bauteiltragenden Platte (2) festgemacht wird.

2. Montiertes Fabrikat nach dem Montageverfahren gemäß Anspruch 1, bestehend aus einer "Flex. P.C." (3), die auf einer Platte (2) und einer Gegenplatte (5) befestigt ist, wobei die Platte (2) und die Gegenplatte (5) aus Hartplastik gepreßt sind, die Elastomer-"Matte" zwischen der "Flex. P.C." und der Gegenplatte gesetzt ist, während die Gegenplatte die Leiter (3a) der "Flex. P.C." (3) gegen die Kontakte (1a) der elektronischen Bauteile (1) drückt, indem diese präzis in gleichförmigen auf der Innenseite der Platte (2) eingearbeiteten Stellen eingesetzt werden.

## Revendications

1. Méthode de montage pour l'application de composants électroniques sur Circuits Imprimés Flexibles ("Flex P.C.") comprenant les suivantes phases opérationnelles:
a) introduction des composants électroniques (1) dans des logements conformes réalisés sur la paroi interne d'une plaque de support (2), moulée dans du matériel plastique rigide;
b) emplacement du "Flex P.C." (3) sur la plaque (2) de manière à ce que les conducteurs (3a), montés sur le "Flex P.C.", soient tournés vers la paroi interne de la plaque (2);
c) insertion d'un "coussinet" en élastomère (4) sur le côté opposé du "Flex P.C." (3);
d) écrasement du "coussinet" (4) contre la plaque (2) au moyen d'une contre-plaque de couverture (5), cette dernière également moulée dans du matériel plastique rigide, serrée au moyen d'outils de fixation adaptés à la plaque porte-composants (2).

2. Produit manufacturé assemblé, obtenu selon la méthode de montage de la première revendication, comprenant un "Flex P.C." (3) serré entre une plaque (2) et une contre-plaque (5), lesdites plaque (2) et contre-plaque (5) étant moulées dans du matériel rigide en plastique, un "coussinet" en élastomère (4) inséré entre le "Flex P.C." et la contre-plaque, à l'endroit où la contre-plaque comprime les conducteurs (3a) du "Flex P.C." (3) contre les contacts (1a) des composants électroniques (1) qui sont exactement positionnés dans des logements conformes et prévus à cet effet sur la paroi interne de la plaque (2).
